# EUROPEAN PATENT SPECIFICATION

(11) **EP 0 622 879 B1**
(45) Date of publication and mention of the grant of the patent: **04.09.1996**
(21) Application number: 94102336.8
(22) Date of filing: 16.02.1994
(51) Int. Cl.: H01S 3/19, H01L 33/00

(54) **Semiconductor laser and production method thereof**
Halbleiterlaser und Herstellungsverfahren
Laser à semi-conducteur et méthode de fabrication

(30) Priority: 28.04.1993 JP 102345/93
(43) Date of publication of application: 02.11.1994
(73) Proprietor: MITSUBISHI DENKI KABUSHIKI KAISHA, Tokyo 100 (JP)
(72) Inventor: Nagai, Yutaka, c/o Mitsubishi Denki K.K., 4-chome, Itami-shi, Hyogo 664 (JP)
(74) Representative: KUHNEN, WACKER & PARTNER

(56) References cited:
- EP-A- 0 452 146
- EP-A- 0 477 013
- GB-A- 2 221 094
- PATENT ABSTRACTS OF JAPAN vol. 15, no. 118 (E-1048) 22 March 1991 & JP-A-03 006 877 (MITSUBISHI ELECTRIC) 14 January 1991
- IEEE PHOTONICS TECHNOLOGY LETTERS, vol.2, no.10, October 1990, NEW YORK, US pages 697 - 698, XP171295 M.JOST ET AL. 'Ridge Formation for AlGaAs GRINSCH Lasers by Cl2 Reactive Ion Etching'
- PATENT ABSTRACTS OF JAPAN vol. 15, no. 454 (E-1135) 19 November 1991 & JP-A-03 194 989 (MITSUBISHI ELECTRIC) 26 August 1991

## Description

### FIELD OF THE INVENTION

The present invention relates to a semiconductor laser and a production method thereof and, more particularly, to those having a p type cladding layer on a light reflecting layer of a buried ridge type semiconductor laser.

### BACKGROUND OF THE INVENTION

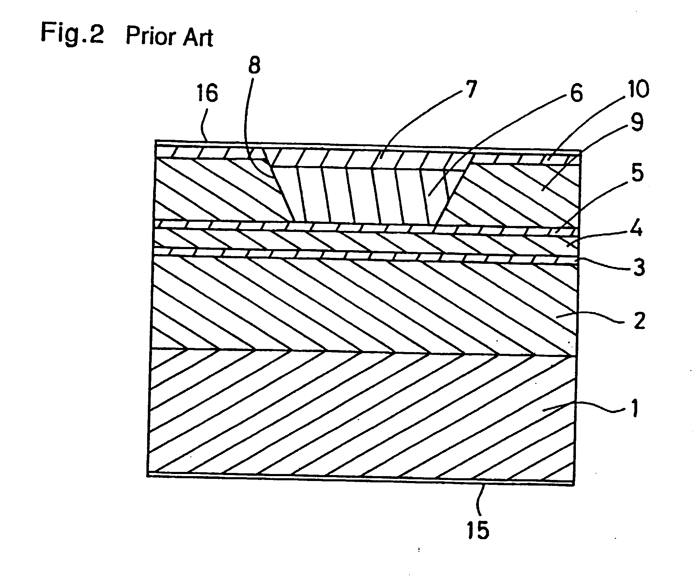

Figure 2 shows a cross-sectional view of a buried ridge type semiconductor laser diode (hereinafter referred to as an ES-LD) with an etching stopper layer (hereinafter referred to as an ES layer).

This laser has an n type GaAs substrate 1 as a substrate. An n type Al_{0.5}Ga_{0.5}As cladding layer 2 is disposed on the n type GaAs substrate 1 and a multi quantum well (hereinafter referred to as MQW) structure active layer 3 comprising GaAs and Al_{0.2}Ga_{0.8}As is disposed on the n type cladding layer 2. A p type Al_{0.5}Ga_{0.5}As first cladding layer 4 and an AlGaAs etching stopper layer 5 having Al composition ratio of above 0.6 are successively disposed on the MQW active layer 3. A p type Al_{0.5}Ga_{0.5}As second cladding layer 6 formed in a ridge shape 8 together with a p type GaAs contact layer 7 formed on the layer 6 and n type GaAs current blocking layers 9 burying the both sides of the ridge 8 and having Zn diffused layers 10 including Zn as p type dopants diffused at its upper portion are disposed on the etching stopper layer 5. An n side electrode 15 is formed on the rear surface of the n type GaAs substrate 1 and a p side electrode 16 is formed on the p type GaAs contact layer 7 and the Zn diffusion layer 10 at the front surface of the device.

A description is given of the operation of this ES-LD.

When to operate the semiconductor laser, a forward direction voltage is applied between the p side electrode 16 and the n side electrode 15, electrons are injected from the side of n type GaAs substrate 1 and holes are injected from the side of p type cap layer (contact layer) 7. The injected holes are confined to the element central portion by the n type GaAs current blocking layers 9, and the electrons and holes are efficiently recombined in the active layer 3 direct below the ridge 8, thus emitting light of wavelength corresponding to the energy gap of the active layer 3. In this prior art device, the emitted light has a wavelength of 780 nm. The light generated direct below the ridge 8 tends to be broadened along the active layer 3 in the horizontal direction, but by the light absorption effect due to the current blocking layers 9 disposed in the vicinity of the active layer 3, an effective refractive index difference is made in the active layer 3 in the horizontal direction, whereby the light is confined within the ridge 8. This light confinement in the device width direction largely depends on the layer thickness of the p type Al_{0.5}Ga_{0.5}As first cladding layer 4, presenting the best device characteristics when the layer thickness is 0.2 - 0.3 µm.

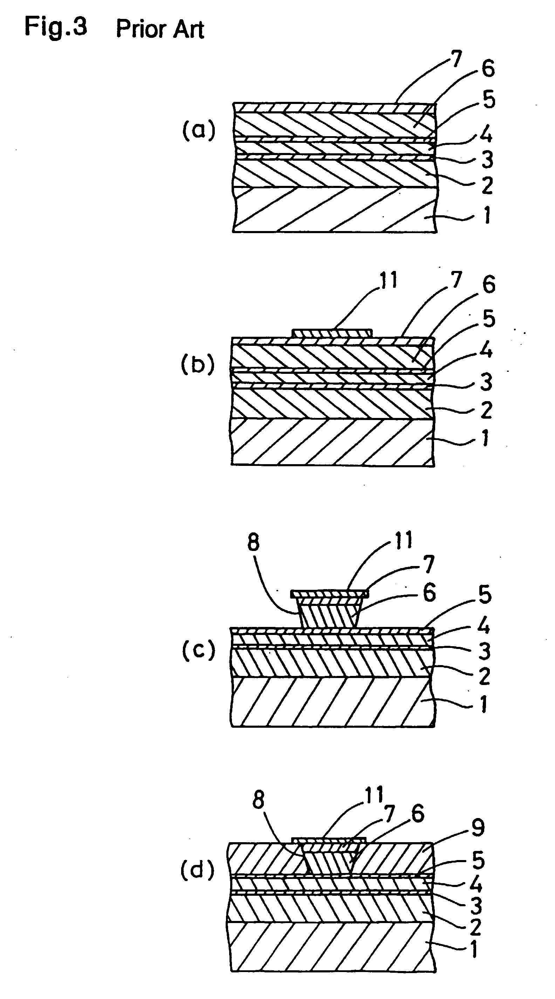

A production method of this ES-LD will be described with reference to figure 3(a) - (d).

Figure 3 illustrates the process flow for forming the ridge portion of the ES-LD shown in figure 2. The same reference numerals in figure 3 are used to designate the same elements as those in figure 2, and reference numeral 11 designates an insulating film.

First of all, as shown in figure 3(a), on the n type GaAs substrate 1, epitaxial growth is carried out by, for example, MOCVD (metal organic chemical vapor deposition) to successively grow the n type AlGaAs cladding layer 2, the active layer 3, the p type AlGaAs first cladding layer 4, the AlGaAs etching stopper layer 5, the p type AlGaAs second cladding layer 6, and the p type GaAs contact layer 7.

Thereafter, an insulating film serving as an etching mask comprising such as SiN or SiO is formed on the wafer by sputtering, thermal CVD, or plasma CVD, and photoresist is plated on the insulating film 11 and photolithography and etching are performed to form a stripe shaped insulating film 11 having a width corresponding to the width of a ridge that is produced later.

Next, as shown in figure 3(c), portions of the contact layer 7 and portions of the second cladding layer 6 other than those at the ridge portion are removed by etching, employing the insulating film 11 as an etching mask. Then, the stoppage of etching is achieved by the etching stopper layer 5 by employing an etchant that does not etch AlGaAs layer having an Al composition ratio of above 0.6, but etches AlGaAs layer having an Al composition ratio below 0.6. For example, a mixed solution of tartaric acid and hydrogen peroxide can be employed. Thereby, it is possible to keep the thickness of the p type first cladding layer 4 which greatly affects the device characteristics constant, thereby providing a preferable device characteristics.

Thereafter, an epitaxial growth is again carried out to grow the n type GaAs current blocking layers 9 at the both sides of the ridge 8, thereby burying the ridge 8 (figure 3(d)).

Finally, Zn diffusion regions 10 are formed at upper portions of the current blocking layers 9 by such as ion implantation employing the film 11 as a mask, and then the insulating film 11 is removed, thereby completing the device. Here, the diffusion of Zn may be performed by solid phase diffusion.

The prior art ES-LD is constructed as described above, and the current blocking layer 9 is formed on the etching stopper layer 5 having an Al composition ratio of above 0.6. However, since an AlGaAs layer having a high Al composition ratio has a thick surface oxidation film, when crystal growth is carried out thereon, a lot of surface defects occur to an amount of above 10⁶/cm², thereby eminently deteriorating surface morphology. In addition, as a result of that, a leak current which flows through the surface defects in the operation and makes no contribution to the device operation at all, increases with time, thereby eminently deteriorating the reliability of the device.

Examples for semiconductor laser devices with etch stopper layers are disclosed in EP-A-0 452 146 and EP-A-0 477 013. Semiconductor laser devices which use a light interference method in order to etch a cladding layer are disclosed in GB-A-2 221 094, JP-A-3 006 877, JP-A-3 194 989 and in IEEE Photonics Technology Letters, 2(1990) 10, pp.697-698.

### SUMMARY OF THE INVENTION

It is an object of the present invention, as defined in Claim 1, to provide a semiconductor laser that has grown a current blocking layer on a thin film of a second conductivity type, .i.e., a p type second cladding layer having a low surface defect density, and that has a preferable device characteristics and a high device reliability.

It is another object of the present invention, as defined in Claim 5, to provide a production method of a semiconductor laser that can produce a thin film layer of a second conductivity type second cladding layer at high reproducibility and that can provide the device characteristics of high reproducibility and high uniformity.

Other objects and advantages of the present invention will become apparent from the detailed description given hereinafter; it should be understood, however, that the detailed description and specific embodiment are given by way of illustration only, since various changes and modifications within the scope of the invention will become apparent to the those skilled in the art from this detailed description.

According to a first aspect of the present invention, a semiconductor laser device includes: a first conductivity type semiconductor substrate; a first conductivity type lower cladding layer disposed on the first conductivity type semiconductor substrate; an active layer disposed on the lower cladding layer; a second conductivity type first upper cladding layer disposed on the active layer; a second conductivity type Al_{z}Ga_{1-z}As light reflecting layer disposed on the first upper cladding layer, where z is equal to or larger than 0.6; a second conductivity type second upper cladding layer comprising Al_{y}Ga_{1-y}As including a stripe shaped ridge region portion and thin film layer portions, disposed on the light reflecting layer; and first conductivity type current blocking layers disposed on the both side thin film portions of the second upper cladding layer so as to bury the ridge region portion.

By this construction, the surface defect density can be reduced from 10⁶/cm² of the prior art to 10⁴/cm², thereby the surface mohology is improved to a great extent, and a high reliability semiconductor laser device having a preferable device characteristics is obtained.

According to a second aspect of the present invention, semiconductor laser device has a total thickness of the first upper cladding layer, the light reflecting layer, and the thin film layer portion of second upper cladding layer equal to or lower than 0.3 µm.

By this construction, there arises no idle current which otherwise arises due to the injected current being broadened in the transverse direction under the current blocking layers, whereby a preferable device characteristics is obtained.

According to a third aspect of the present invention, a production method of a semiconductor device includes: on a first semiconductor substrate epitaxially growing successively a first conductivity type lower cladding layer, an active layer, a second conductivity type first upper cladding layer, a second conductivity type Al_{z}Ga_{1-z}As light reflecting layer, where z is equal to or larger than 0.6, a second conductivity type second upper cladding layer comprising Al_{y}Ga_{1-y}As, and a second conductivity type contact layer; carrying out an etching to the first contact layer and the second upper cladding layer, thereby producing a stripe shaped ridge region portion as well as leaving thin film layer portions of the second upper cladding layer at both sides of the ridge region; crystalline growing first conductivity type current blocking layers on the thin film layer portions of the second upper cladding layer so as to bury the ridge region portion; and producing a second conductivity type contact layer over the entire top surface of the ridge region portion and the current blocking layers.

By this construction, the surface morphology is greatly improved, and a high reliability semiconductor laser device having a preferable device characteristics is fabricated.

According to a fourth and a fifth aspect of the present invention, the process of leaving the thin film layer portions at both sides of the second upper cladding layer, comprises observing the interference light which is obtained by that light which is irradiated to the second upper cladding layer that becomes gradually thinner by the ridge etching and passes through this second upper cladding layer, is reflected by the light reflecting layer and this reflected light is interfered with the incident light passing through the second upper cladding layer, and stopping the etching when a predetermined time passed from when the interference light begins to be seen, or when the particular wavelength light is observed a predetermined number of times.

By changing the time or the number of times for stopping the etching, the thickness of the thin film layer can be controlled, and therefore, the second upper cladding layer can be made thin at high reproducibility and, a high reliability semiconductor laser device that is superior in the reproducibility and uniformity of device characteristics is obtained.

According to a sixth aspect of the present invention, the process of leaving the thin film layer portions at both sides of the second upper cladding layer, comprises after producing up to the contact layer, producing a groove having a depth corresponding to the layer thickness of the thin film layer at the surface of the contact layer which is subjected to ridge etching, observing the interference light which is obtained by that light which is irradiated to the second upper cladding layer at the groove portion that becomes gradually thinner by the ridge etching and passes through this second upper cladding layer is reflected by the light reflecting layer and the reflected light is interfered with the incident light passing through the second upper cladding layer at the groove portion, and stopping the etching when the interference light disappears, so as to leave thin film layer portions at both sides of the second upper cladding layer.

By this method, the thin film portions of the second upper cladding layer can be left at a higher preciseness on the light reflecting layer and, a high reliability semiconductor laser device superior in the reproducibility and uniformity of the device characteristics is obtained.

### BRIEF DESCRIPTION OF THE DRAWINGS

Figure 1 is a cross-sectional view of a semiconductor laser according to a first embodiment of the present invention.

Figure 2 is a cross-sectional view of a prior art semiconductor laser.

Figure 3 is a diagram for explaining the production method of the prior art semiconductor laser.

Figure 4 is a diagram for explaining the production method of the first embodiment of the present invention.

Figure 5 is a diagram for explaining the production method of the second embodiment of the present invention.

Figure 6 is a diagram for explaining the production method of the third embodiment of the present invention.

### DETAILED DESCRIPTION OF THE PREFERRED EMBODIMENT

### Embodiment 1.

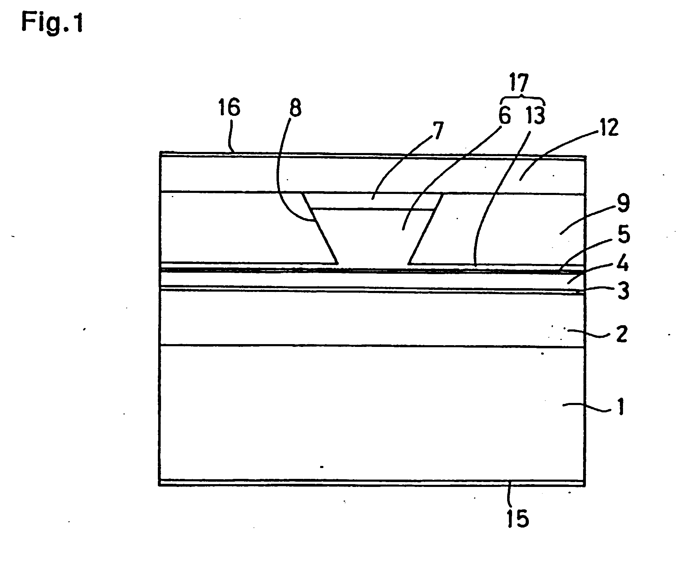

Figure 1 is a diagram showing a structure of a semiconductor laser according to a first embodiment of the present invention. The same reference numerals are used to designate the same or corresponding elements.

This semiconductor laser has a GaAs substrate 1 as a substrate. On the n type GaAs substrate 1, successively disposed an n type Al_{0.5}Ga_{0.5}As cladding layer 2 having an Al composition ratio of 0.5, a film thickness of 1.0 to 2.0 µm, and a carrier concentration of 5.0 x 10¹⁷ cm⁻³; a multi-quantum well (MQW) structure alternatively laminating a plurality of GaAs layers and AlGaAs layers having an Al composition of below 0.15 and having a thickness of below 0.2 µm; a p type Al_{0.5}Ga_{0.5}As first cladding layer 4 having an Al composition ratio of 0.5, a film thickness of 0.2 to 0.4 µm, and a carrier concentration of 2.0 x 10¹⁸cm⁻³; and an Al_{z}Ga_{1-z}As light reflecting layer 5 having an Al composition ratio z of above 0.6, a film thickness of below 0.1 µm, and a carrier concentration of 2.0 x 10¹⁸cm⁻³. Furthermore, on the light reflecting layer 5, a p type Al_{0.5}Ga_{0.5}As second cladding layer 17 comprising a stripe shaped ridge region portion 6 having a bottom edge length of 4 µm, an upper edge length of 6 µm, and a height of 2 µm, and thin film layer portions 13 having a layer thickness of below 3 µm, including the thickness of first cladding layer 4 and that of light reflecting layer 5 thickness, and a carrier concentration of 2.0 x 10¹⁸cm⁻³ is disposed. A p type GaAs contact layer 7 also in a ridge shape is disposed on the ridge region portion 6 of the second cladding layer 17, and both side portions of the ridge region portion 6 are buried by the current blocking layers 9 having a carrier concentration of 1.0 x 10¹⁸cm⁻³. On the entire surface of the ridge region portion 6 and the current blocking layer 9, a p type GaAs first contact layer 12 of 0.5 to 2 µm thickness is disposed. An n side electrode comprising AuGe of 50nm (500 Å) thickness, Ni of 50nm (500 Å) thickness, and Au of 300nm (3000 Å) thickness is disposed on the rear surface of the n type GaAs substrate 1, and a p side electrode comprising Ti of 50nm (500 Å) thickness and Au of 300nm (3000 Å) thickness is disposed on the upper surface of the device. Thus, a semiconductor laser device of 300 µm width, 300 to 600 µm length, and 100 µm height is completed. Here, the composition of the light reflecting layer 5 comprises the same material of Al_{z}Ga_{1-z}As as the etching stopper layer of the prior art semiconductor device.

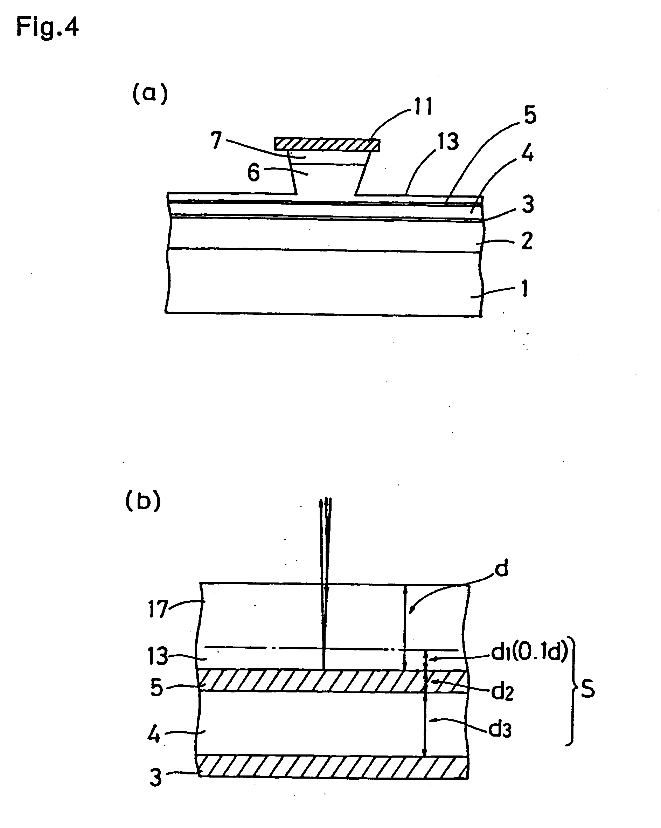

The production method of this first embodiment device will be described with reference to figure 4.

Figure 4 shows a process flow for producing the semiconductor laser of this first embodiment, where figure 4(a) is a cross-sectional view of the wafer that has completed the process of leaving the thin film layer 13 of the second cladding layer 17, and figure 4(b) is a diagram for explaining a method for leaving the thin film layer 13 by stopping the etching when a prescribed time passed from when the interference light which is obtained by that light irradiated to the second cladding layer 17 is reflected by the light reflecting layer 5 and this reflected light is interfered with the incident light, begins to appear or observed.

The production method will be described.

On the n type GaAs substrate 1, successively grown by MOCVD the n type AlGaAs cladding layer 2, the active layer 3, the p type AlGaAs first cladding layer 4, the AlGaAs light reflecting layer 5, the p type AlGaAs second cladding layer 17, and the p type GaAs contact layer 7, and thereafter, the stripe shaped insulating film 11 is formed thereon. Up to this step, the process is the same as that in the prior art method shown in figure 3(a) and 3(b).

Thereafter, a ridge etching is carried out employing a mixed solution of tartaric acid and hydrogen peroxide that can etch an AlGaAs layer having an Al composition ratio of below 0.6, with irradiating light, for example, white light to the second cladding layer 17. Then, accompanying with the layer thickness of the second cladding layer 17 at the etched portion being thinned gradually, light among the incident light existing in the second cladding layer 17 and light among the reflected light by the light reflecting layer 5 are interfered with each other, thereby an interference fringe is observed. Then, interference light having some wavelength components, including, for example, red light of wavelength λ = 650nm (6500 Å), can be observed. This is because the refractive index n1 of the second cladding layer 17 and the refractive index n2 of the light reflecting layer 5 are different from each other and also n2 > n1 stands. Here, the refractive index of AlGaAs is smaller in a higher Al composition ratio.

Meanwhile, if the refractive index of the second cladding layer 17 and the refractive index of the light reflecting layer 5 are constant, the film thickness of the remaining layer 13 of the second upper cladding layer 17 that is obtained when the interference light begins to be observed, for example, about 0.5 µm, is always constant for any wafer, and therefore, the time t from the interference fringe begins to be observed to the interference fringe entirely disappears, is also constant.

Therefore, the time from the interference light begins to be observed by the ridge etching to when the etching reaches up to the light reflecting layer 5, is previously measured by monitoring for the same wafer, and it is set as t (for example, 5 minutes). Then, the etching condition is set such that the etching time is, for example, 0.9t leaving time 0.1t with relative to the total etching time t, and the thickness of the second cladding layer 17 to be left is set to 0.1d corresponding to 0.1t. Supposing that an etching is carried out on that condition, the etching is stopped when time of 0.9t passed after the interference light begins to be observed, and then a thin film layer 13 of layer thickness of 0.1d (d1 is shown in figure 4(b)) is left successfully.

Thereafter, the n type Gaas current blocking layers 9 are buried on the thin film layer 13 other than the ridge region 6 similarly as in the prior art method.

As described above, in this first embodiment, the thin film layer 13 of the second cladding layer 17 is left on the light reflecting layer 5, and the n type GaAs current blocking layer 9 is grown not on the AlGaAs layer having an Al composition ratio of above 0.6 as the etching stopper layer in the prior art method but on the thin film layer 13 of the second cladding layer 17 having an Al composition ratio that is smaller than that of the light reflecting layer 5, for example, about 0.5. Therefore, the surface defect density on the thin film layer 13 of the p type cladding layer 17 is drastically reduced from 10⁶cm⁻² to 10⁴cm⁻², and the surface morphology is largely improved. This also leads to large reduction in the leakage current flowing through the defects, whereby the device characteristics is greatly improved and the device reliability is also greatly improved.

In addition, the lamination layer thickness S of p type layers other than at the ridge region 6, that is,$\text{S = ( layer thickness d1 of the thin film layer 13 of} \text{the p type second upper cladding layer 17 )} \text{+ ( layer thickness d2 of the light reflecting layer} \text{5 )} \text{+ ( layer thickness d3 of the p type first upper} \text{cladding layer 4 )}$ is desired to be controlled within an error of ±0.05 µm in a range of S < 0.3 µm so as to keep the threshold current of the laser small. It is because when this lamination layer thickness S is larger, the current is broadened in the transverse direction and the threshold current is heightened. The layer thickness d2 of the light reflecting layer 5 and the layer thickness d3 of the cladding layer 4 can be controlled at high preciseness during the epitaxial growth, and by controlling the thickness dl of the thin film layer 13 by the above-described method at high preciseness, the total thickness of the p type first upper cladding layer 4, the light reflecting layer 5, and the thin film layer 13 of the p type second upper cladding layer 17 can be controlled at high preciseness to below 0.3 µm, and thereby the broadening of the current in the transverse direction can be reduced and a high reliability semiconductor laser having a uniform device characteristics is obtained.

In addition, by observing the interference light of the light reflected by the light reflecting layer 5 and stopping the etching when a predetermined time of 0.9t has passed after the interference light begins to be seen, the thin film layer 13 of thickness 0.1d corresponding to the time 0.1t during which the second p type cladding layer 17 entirely disappears is left, and the control of the thickness of the thin film layer is quite eased, and a semiconductor laser device having high reproducibility and high uniformity of device characteristics is obtained.

### Embodiment 2.

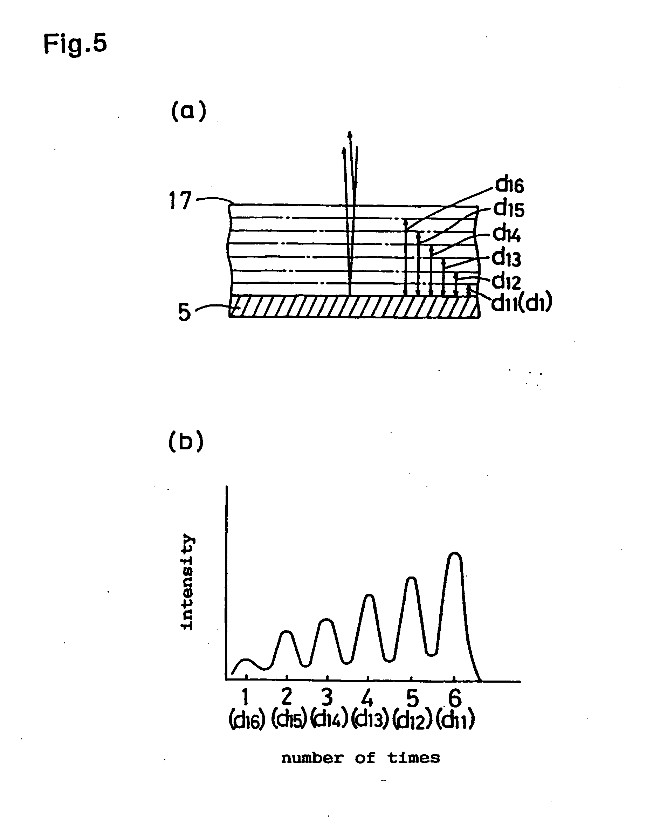

Figure 5 is a diagram for explaining a production method of a semiconductor laser according to a second embodiment of the present invention, where figure 5(a) is a diagram for explaining the method of counting the number of times when the interference light of a particular wavelength obtained by incident light reflected by the light reflecting layer 5 periodically appears and stopping the etching when observations of a predetermined number of times has passed, thereby leaving a thin film layer of the second p type upper cladding layer, and figure 5(b) is a diagram showing the interference light that is periodically observed.

In this second embodiment, similarly as in the production method of the first embodiment, respective layers of the n type AlGaAs lower cladding layer 2, the active layer 3, the p type AlGaAs first upper cladding layer 4, the AlGaAs light reflecting layer 5, the p type AlGaAs second upper cladding layer 17, and the p type GaAs contact layer 7 are successively grown by MOCVD on the n type GaAs substrate 1, and thereafter, a stripe shaped insulating film 11 is formed, and a ridge etching is carried out by a mixed solution of tartaric acid and hydrogen peroxide that can etch an AlGaAs layer having an Al composition ratio of below 0.6 employing the insulating film 11 as an etching mask, thereby producing a thin film layer 13 as shown in figure 4(a), and meanwhile, the thin film layer 13 is left by observing the timings when the interference light strongly appears periodically with counting the number of the timings until the cladding layer 17 entirely disappears, and stopping the etching when the observations of the predetermined number of times has passed.

In other words, while the color of the interference light that is generated during when the p type cladding layer 17 is ridge etched changes with the proceeding of the etching, its wavelength λ satisfies the following formula (1).$\text{N · λ / 2 = n · d}$ where
- λ:: wavelength of light
- n:: refractive index of the p type cladding layer 13
- N :: integer
- d :: layer thickness of the p type cladding layer 13.

The color (wavelength) of the interference light changes with the layer thickness of the p type second cladding layer 17, and a particular wavelength appears periodically. More particularly, when the interference light begins to be observed from the layer thickness d of N · λ / 2n, the same wavelength light is observed N times until the etching reaches the light reflection layer 5.

Accordingly, when the number of times N that the interference light of a particular wavelength, such as red light, is previously measured by monitoring the wafer of the same construction and the etching is stopped when the observation of the interference light is repeated N times while performing a ridge etching to the p type second cladding layer 7, the remaining layer thickness d1 of the p type second cladding layer 17 becomes as in the formula (2),$\text{d1 = λ / 2n}$ where
- λ:: wavelength of light
- n :: refractive index of the p type cladding layer 13
- N :: integer
- d1:: remaining layer thickness of the p type cladding layer 13.

Here, although the number of times N that the interference light of the particular wavelength repeatedly appears can be obtained also theoretically, it is preferable to determine the number of times N from the result of performing monitoring on the same construction wafer because the determination of the timing when the interference light actually begins to be observed includes difficulty in determining what kind of state is a state that the interference light begins to be observed.

In this way, when light, for example, white light is irradiated to a part of the second upper cladding layer 17 which part is etched during the ridge etching, there arises an interference between the incident light in the p type second cladding layer 17 and the light reflected by the light reflecting layer 5, and each time when the layer thickness d of the p type second upper cladding layer 17 that becomes gradually thinner becomes an integer multiple of a predetermined wavelength λ (for example, λ = 650nm (6500 Å)), the light of that wavelength λ, appears strongly. Therefore, in this second embodiment, as the p type second upper cladding layer 17 becomes successively thinner to be layer thickness d16, d15, d14, d13, d12, and d11(= d1), the interference light changes its wavelength, i.e., its color, successively. When consideration is paid on a particular wavelength, for example, red light of wavelength λ = 650nm (6500 Å)), the interference light of this red light is observed six times as shown in figure 5(b) as the layer thickness d16 to d11 (= d1) of the p type second cladding layer 17 becomes thinner. Therefore, by stopping the etching when the interference light is seen six times while carrying out the ridge etching with observing the interference light, it is possible to leave a desired layer thickness d11(= d1) as the thin film layer 13 of the second upper cladding layer 17. Here, the layer thickness of the second upper cladding layer 17 corresponding to the time from the interference light of red light is seen to that is also seen next is, for example, 0.094 µm, and its value is obtained from the above wavelength λ of the interference light and the refractive index n (about 3.5) of the p type second upper cladding layer 17.

In this way, in the production method of this second embodiment, the etching is stopped when interference light of a particular wavelength that appears periodically repeatedly is seen N times, to obtain the thin film layer 13 of the p type second upper cladding layer 17, and the layer thickness d1 of the finally remaining p type upper cladding layer thin film layer 13d can be made a desired value, thereby resulting in a high precise control of the thin film layer 13.

### Embodiment 3.

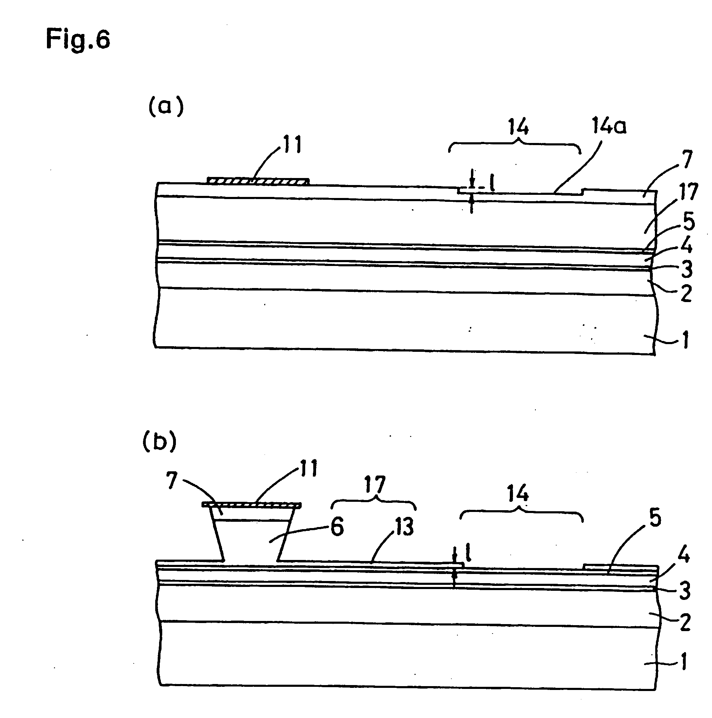

Figure 6 is a diagram for explaining the production method of a semiconductor laser according to a third embodiment of the present invention, where figure 6(a) is a cross-sectional view of a wafer before the ridge etching is started, and figure 6(b) is a cross-sectional view of the wafer when the ridge etching is completed. In the figure, the same reference numerals are used to designate the same or corresponding elements as in figure 1. Reference numeral 14 designates a monitor region (hereinafter also referred to as a groove region), and reference numeral 14a designates a bottom region of the monitor region 14.

In this third embodiment, similarly as in the above embodiments, after producing the contact layer 7 a groove region 14 of a depth corresponding to the thickness of the thin film layer 13 of the p type second upper cladding layer 17 is formed at the surface of the contact layer 7 other than at the ridge region, and thereafter, a ridge etching is carried out, and by stopping the ridge etching when the bottom surface 14a of the groove region 14 reaches the light reflecting layer 5, the thin film layer 13 of the p type second upper cladding layer 17 is left to a thickness equal to the depth of the groove region 14.

The method of this embodiment will be described in detail.

First of all, similarly as in the first embodiment, the n type AlGaAs cladding layer 2, the active layer 3, the p type AlGaAs first upper cladding layer 4, the AlGaAs light reflecting layer 5, the p type AlGaAs second upper cladding layer 17, and the p type contact layer 7 are successively grown by such as MOCVD, and thereafter, the stripe shaped insulating film 11 is produced.

Next, as shown in figure 6(a), a monitor region 14 of groove shape of depth 1 is produced at a surface other than the region to become a device region on the p type GaAs contact layer 7. The depth 1 of the monitor region 14 can be measured by a surface roughness meter or a step meter.

Next, a ridge etching is carried out by a mixed solution of tartaric acid and hydrogen peroxide, and the contact layer 7 and the p type second upper cladding layer 17 are successively etched at the same speed uniformly. When white light is irradiated during this etching, it can be observed that the interference light, for example, red light of λ = 650 nm (6500 Å) that is obtained by that the irradiated light is reflected by the light reflecting layer 5 and interfered with the incident light appears or not at the monitor region 14. Then, the interference light repeats to appear strongly or weakly dependent on the varying layer thickness, and when the bottom surface 14a of the monitor region 14 reaches the light reflecting layer 5, that is, when the p type second upper cladding layer 17 at the monitor region 14 is completely gone, the interference light is completely gone, and at this timing the etching is stopped. Thereby, the thin film layer 13 of the p type second upper cladding layer 17 is just left to a thickness of 1 other than at the monitor region 14.

In this third embodiment, a groove shaped monitor region 14 of a depth 1 corresponding to the film thickness d1 of the thin film layer 13 is formed at the surface of the contact layer 7, and when the interference light is completely gone with the bottom surface 14a of the monitor region 14 reaching the light reflecting layer 5, the etching is stopped. Therefore, the thin film layer 13 of the p type second upper cladding layer 17 can be left by a thickness of 1 on the light reflecting layer 5, and in addition to the effect of the first embodiment, a thin film layer of a required thickness can be obtained to quite a thin and quite a precise thickness. In addition, because the etching is stopped when the interference light is gone during observing the interference light, the conclusion point detection can be performed quite easily.

In the above-described first to third embodiments, the conductivity types of the respective semiconductor layers can be converted from p type to n type, or from n type to p type with the same effects as described above.

In the above-described first to third embodiments, materials of AlGaAs system are employed for the active layer 3, but the present invention can be applied to a case where a laser of oscillation wavelength of about 800 nm employing other materials such as InGaAsP with the same effects as described above.

According to a first embodiment of the present invention, a semiconductor laser device includes: a first conductivity type semiconductor substrate; a first conductivity type lower cladding layer disposed on the first conductivity type semiconductor substrate; an active layer disposed on the lower cladding layer; a second conductivity type first upper cladding layer disposed on the active layer; a second conductivity type Al_{z}Ga_{1-z}As light reflecting layer disposed on the first upper cladding layer, where z is equal to or larger than 0.6; a second conductivity type second upper cladding layer comprising Al_{y}Ga_{1-y}As including a stripe shaped ridge region portion and thin film layer portions, disposed on the light reflecting layer; and first conductivity type current blocking layers disposed on the both side thin film portions of the second upper cladding layer so as to bury the ridge region portion.

Therefore, the surface defect density can be reduced from 10⁶/cm² of the prior art to 10⁴/cm², and thus the surface morphology is improved to a great extent and a high reliability semiconductor laser device having a preferable device characteristics is obtained.

According to a second embodiment of the present invention, a semiconductor laser device has a total thickness of the first upper cladding layer, the light reflecting layer, and the thin film layer portion of the second upper cladding layer, equal to or lower than 0.3 µm.

Therefore, there arises no idle current which otherwise arises due to the injected current being broadened in the transverse direction under the current blocking layers, whereby a preferable device characteristics is obtained.

According to a third embodiment of the present invention, a production method of a semiconductor laser device includes: on a first conductivity type semiconductor substrate, epitaxially growing successively a first conductivity type lower cladding layer, an active layer, a second conductivity type first upper cladding layer, a second conductivity type Al_{z}Ga_{1-z}As light reflecting layer where z is equal to or larger than 0.6, a second conductivity type second upper cladding layer comprising Al_{y}Ga_{1-y}As, and a second conductivity type first contact layer; carrying out an etching to the first contact layer and the second upper cladding layer, thereby producing a stripe shaped ridge region portion as well as leaving thin film layer portions of the second upper cladding layer at both sides of the ridge region; crystalline growing first conductivity type current blocking layers on the thin film layer portions of the second upper cladding layer so as to bury the ridge region portion; and producing a second conductivity type second contact layer over the entire top surface of the ridge region portion and the current blocking layers.

Therefore, the surface morphology is largely improved, and a high reliability semiconductor laser device having a preferable device characteristics is fabricated.

According to a fourth and a fifth embodiment of the present invention, the process of leaving the thin film layer portions at both sides of the second upper cladding layer, comprises observing the interference light which is obtained by that light which is irradiated to the second upper cladding layer that becomes gradually thinner by the ridge etching and passes through the second upper cladding layer is reflected by the light reflecting layer and is interfered with the incident light passing through the second upper cladding layer, and stopping the etching when a predetermined time passed from when the interference light begins to be seen, or when a particular wavelength light is observed a predetermined number of times.

Therefore, by changing the time or the number of times for stopping the etching, the thickness of the thin film layer can be controlled, and therefore, the second upper cladding layer can be made thin at high reproducibility, and a high reliability semiconductor laser device that is superior in the reproducibility and uniformity of device characteristics is obtained.

According to a sixth embodiment of the present invention, the process of leaving the thin film layer portions at both sides of the second upper cladding layer, comprises after producing up to the first contact layer, producing a groove having a depth corresponding to the layer thickness of the thin film layer at the surface of the first contact layer which is subjected to ridge etching, observing the interference light obtained by that light which is irradiated to the second upper cladding layer at the groove portion that becomes gradually thinner by the ridge etching and transmits the second upper cladding layer is reflected by the light reflecting layer and is interfered with the incident light passing through the second upper cladding layer at the groove portion, and stopping the etching when the interference light disappears, so as to leave thin film layer portions at both sides of the second upper cladding layer.

Therefore, the thin film layer portions of the second upper cladding layer can be left at a higher preciseness on the light reflecting layer and, a high reliability semiconductor laser device superior in the reproducibility and uniformity of the device characteristics is obtained.

## Claims

1. A semiconductor laser device, comprising:
a first conductivity type semiconductor substrate (1);
a first conductivity type lower cladding layer (2) disposed on said first conductivity type semiconductor substrate (1);
an active layer (3) disposed on said lower cladding layer (2);
a second conductivity type first upper cladding layer (4) disposed on said active layer (3), said second conductivity type is opposite conductivity type to said first conductivity type;
a second conductivity type Al_{z}Ga_{1-z}As light reflecting layer (5) for reflecting light being incident on this layer during growth of the laser device disposed on said first upper cladding layer (4), where z is equal to or larger than 0.6;
a second conductivity type second upper cladding layer (17) comprising Al_{y}Ga_{1-y}As, where Al composition ratio y is less than said Al composition ratio z, including a stripe shaped ridge region portion (6) provided at the center of the device to produce a stripe shaped ridge and thin film layer portions (13) provided at the both lateral sides of said stripe shaped ridge region portion (6) connected to a bottom portion of said stripe shaped ridge region portion (6), disposed on said light reflecting layer (5); and
first conductivity type current blocking layers (9) disposed on said both side thin film portions (13) of said second upper cladding layer (17) so as to bury said ridge region portion (6) of said second upper cladding layer (17) producing a stripe shaped ridge.

2. The semiconductor laser device of claim 1, which further comprises:
a second conductivity first contact layer (7) disposed on said striped shaped ridge region portion (6) of said second upper cladding layer (17) to produce a stripe shaped ridge (8) together with said stripe shaped ridge region portion (6) of said second upper cladding layer (17);
said first conductivity type current blocking layers (9) disposed so as to bury said stripe shaped ridge (8) comprising said ridge region portion (6) of said second upper cladding layer (17) and said first constant layer (7).

3. The semiconductor laser device of claim 1 or 2, wherein the total thickness of said first upper cladding layer (4), said light reflecting layer (5), said thin film layer portion (13) of second upper cladding layer (17), is equal to or lower than 0.3 µm.

4. The semiconductor laser device of any of claim 1 ∼ 3, wherein said first conductivity type is n type, and said second conductivity type is p type.

5. A production method of a semiconductor device, comprising:
on a first semiconductor substrate (1), successively epitaxially growing a first conductivity type lower cladding layer (2), an active layer (3), a second conductivity type first upper cladding layer(4), a second conductivity type Al_{z}Ga_{1-z}As light reflecting layer (5), where z is equal to or larger than 0.6, a second conductivity type second upper cladding layer (17) comprising Al_{y}Ga_{1-y}As, where Al composition ratio y is less than said Al composition ratio z, and a second conductivity type contact layer formation layer (7);
carrying out an etching to said first contact layer formation layer (7) and said second upper cladding layer (17), thereby producing a stripe shaped ridge (8) comprising a first contact layer (7) and a stripe shaped ridge region portion (6) of said second upper cladding layer (17) as well as leaving thin film layer portions (13) of said second upper cladding layer (17) connected to a bottom portion of said ridge region portion (6) of said second upper cladding layer (17) at both lateral sides of said stripe shaped ridge (8), which etching is controlled by observing the interference light which is obtained from reflected light which result from light irradiated to the second upper cladding layer and after passing through said second upper cladding layer is incident on the light reflecting layer .
crystalline growing first conductivity type current blocking layers (9) on said thin film layer portions (13) of said second upper cladding layer (17) so as to bury said stripe shaped ridge (8); and
producing a second conductivity type contact layer (12) over the entire top surface of said first contact layer (7) of said stripe shaped ridge (8) and said current blocking layers (9) burying the both lateral sides thereof.

6. The production method of a semiconductor laser device of claim 5, wherein said process of leaving said thin film layer portion (13) of said second upper cladding layer (17) comprises:
observing interference light which is obtained by that light irradiated to said second upper cladding layer (17) that becomes gradually thinner by the ridge etching and passing through said second upper cladding layer (17) is reflected by said light reflecting layer (5) to be interfered with the incident light passing through said second upper cladding layer (17); and
stopping said ridge etching when a predetermined time passed from when said interference light begins to be seen, so as to leave thin film layer portions (13) of said second upper cladding layer (17) at both lateral sides of said stripe shaped ridge (8).

7. The production method of a semiconductor laser device of claim 5, wherein said process of leaving said thin film layer portions (13) of said second upper cladding layer (17) comprises:
observing light of a particular wavelength among interference light which is obtained by that light irradiated to said second upper cladding layer (17) that becomes gradually thinner by the ridge etching and passing through said second upper cladding layer (17) is reflected by said light reflecting layer (5) to be interfered with the incident light passing through said second upper cladding layer (17); and
stopping said ridge etching when light of said particular wavelength light is observed a predetermined number of times, thereby leaving thin film layer portions (13) of said second upper cladding layer (17) at both lateral sides of said stripe shaped ridge (18).

8. The production method of a semiconductor laser device of claim 4, wherein said process of leaving said thin film layer portions (13) comprises:
after producing up to said contact layer (7), producing in a monitor region (14) a groove having a depth corresponding to a layer thickness of said thin film layer at a top surface of said contact layer (7) that is subjected to ridge etching and which monitor region (14) is situated outside the region to become a laser device region observing interference light which is obtained by that light irradiated to said second upper cladding layer (17) at said groove portion that becomes gradually thinner by the ridge etching and passing through said second upper cladding layer (17) is reflected by said light reflecting layer (5) to be interfered with the incident light passing through said second upper cladding layer (17) at said groove portion ; and
stopping said etching when said interference light disappears, thereby leaving thin film layer portions (13) at both sides of said ridge region portion (6) of said second upper cladding layer (17).

## Patentansprüche

1. Halbleiterlaservorrichtung, die aufweist:
ein Halbleitersubstrat (1) eines ersten Leitfähigkeitstyps;
eine untere Beschichtungslage (2) des ersten Leitfähigkeitstyps, die auf dem Halbleitersubstrat (1) des ersten Leitfähigkeitstyps angeordnet ist;
eine aktive Schicht (3), die auf der unteren Beschichtungslage (2) angeordnet ist;
eine erste obere Beschichtungslage (4) eines zweiten Leitfähigkeitstyps, die auf der aktiven Schicht (3) angeordnet ist, wobei der zweite Leitfähigkeitstyp zu dem ersten Leitfähigkeitstyp entgegengesetzt ist;
eine Al_{z}Ga_{1-z}As-Lichtreflexionsschicht (5) des zweiten Leitfähigkeitstyps zum Reflektieren von Licht, das während eines Wachstums der Laservorrichtung auf diese Schicht einfällt, die auf der ersten oberen Beschichtungslage (4) angeordnet ist, wobei z gleich oder größer als 0.6 ist;
eine auf der Lichtreflexionsschicht (5) angeordnete zweite obere Beschichtungslage (17) des zweiten Leitfähigkeitstyps, die Al_{y}Ga_{1-y}As aufweist, wobei das Zusammensetzungsverhältnis y von Al niedriger als das Zusammensetzungsverhältnis z von Al ist, die einen streifenförmigen Stegbereichsabschnitt (6), der in der Mitte der Vorrichtung vorgesehen ist, um einen streifenförmigen Steg herzustellen, und Dünnfilmschichtabschnitte (13) beinhaltet, die an den beiden seitlichen Seiten des streifenförmigen Stegbereichsabschnitts (6) vorgesehen sind, die mit einem Bodenabschnitt des streifenförmigen Stegbereichsabschnitts (6) verbunden sind; und
Stromsperrschichten (9) des ersten Leitfähigkeitstyps, die auf den beiden seitlichen Dünnfilmabschnitten (13) der zweiten oberen Beschichtungslage (17) angeordnet sind, um den Stegbereichsabschnitt (6) der zweiten oberen Beschichtungslage (17), die einen streifenförmigen Steg herstellt, zu vergraben.

2. Halbleiterlaservorrichtung nach Anspruch 1, welche weiterhin aufweist:
eine erste Kontaktschicht (7) des zweiten Leitfähigkeitstyps, die auf dem streifenförmigen Stegbereichsabschnitt (6) der zweiten oberen Beschichtungslage (17) angeordnet ist, um einen streifenförmigen Steg (8) zusammen mit dem streifenförmigen Stegbereichsabschnitt (6) der zweiten oberen Beschichtungslage (17) herzustellen;
wobei die Stromsperrschichten (9) des ersten Leitfähigkeitstyps so angeordnet sind, daß sie den streifenförmigen Steg (8), der den Stegbereichsabschnitt (6) der zweiten oberen Beschichtungslage (17) und die erste Kontaktschicht (7) aufweist, vergraben.

3. Halbleiterlaservorrichtung nach Anspruch 1 oder 2, bei der die gesamte Dicke der ersten oberen Beschichtungslage (4), der Lichtreflexionsschicht (5), des Dünnfilmschichtabschnitts (13) der zweiten oberen Beschichtungslage (17) gleich oder kleiner als 0.3 µm ist.

4. Halbleiterlaservorrichtung nach einem der Ansprüche 1 bis 3, bei der der erste Leitfähigkeitstyp der n-Typ ist und der zweite Leitfähigkeitstyp der p-Typ ist.

5. Herstellungsverfahren einer Halbleitervorrichtung, das die folgenden Schritte aufweist:
aufeinanderfolgendes epitaxiales Aufwachsen einer unteren Beschichtungslage (2) eines ersten Leitfähigkeitstyps, einer aktiven Schicht (3), einer ersten oberen Beschichtungslage (4) eines zweiten Leitfähigkeitstyps, einer Al_{z}Ga_{1-z}As-Lichtreflexionsschicht (5) des zweiten Leitfähigkeitstyps, wobei z gleich oder größer als 0.6 ist, einer zweiten oberen Beschichtungslage (17) des zweiten Leitfähigkeitstyps, die Al_{y}Ga_{1-y}As aufweist, wobei das Zusammensetzungsverhältnis y von Al niedriger als das Zusammensetzungsverhältnis z von Al ist, und einer Kontaktschichtausbildungsschicht (7) des zweiten Leitfähigkeitstyps auf ein erstes Halbleitersubstrat (1);
Ausführen eines Ätzens an der ersten Kontaktschichtausbildungsschicht (7) und der zweiten oberen Beschichtungslage (17), wodurch ein streifenförmiger Steg (8) hergestellt wird, der eine erste Kontaktschicht (7) und einen streifenförmigen Stegbereichsabschnitt (6) der zweiten oberen Beschichtungslage (17) aufweist, als auch Zurücklassen von Dünnfilmschichtabschnitten (13) der zweiten oberen Beschichtungslage (17), die an beiden seitlichen Seiten des streifenförmigen Stegs (8) mit einem Bodenabschnitt des Stegbereichsabschnitts (6) der zweiten oberen Beschichtungslage (17) verbunden sind, wobei dieses Ätzen durch ein Überwachen des Interferenzlichts gesteuert wird, welches von reflektiertem Licht erzielt wird, welches von Licht bewirkt wird, welches auf die zweite obere Beschichtungslage strahlt und nach einem Durchlaufen der zweiten oberen Beschichtungslage auf die Lichtreflexionsschicht einfällt;
kristallines Aufwachsen von Stromsperrschichten (9) des ersten Leitfähigkeitstyps auf die Dünnfilmschichtabschnitte (13) der zweiten oberen Beschichtungslage (17), um den streifenförmigen Steg (8) zu vergraben; und
Herstellen einer Kontaktschicht (12) des zweiten Leitfähigkeitstyps über der gesamten oberen Oberfläche der ersten Kontaktschicht (7) des streifenförmigen Stegs (8) und der Stromsperrschichten (9), die die beiden seitlichen Seiten davon vergraben.

6. Herstellungsverfahren einer Halbleiterlaservorrichtung nach Anspruch 5, bei dem das Verfahren eines Zurücklassens des Dünnfilmschichtabschnitts (13) der zweiten oberen Beschichtungslage (17) die folgenden Schritte aufweist:
Überwachen eines Interferenzlichts, welches dadurch erzielt wird, daß Licht, das auf die zweite obere Beschichtungslage (17) strahlt, die durch das Ätzen des Stegs allmählich dünner wird, und durch die zweite obere Beschichtungslage (17) läuft, von der Lichtreflexionsschicht (5) reflektiert wird, um mit dem einfallenden Licht, das durch die zweite obere Beschichtungslage (17) läuft, zu interferieren; und
Stoppen des Ätzen des Stegs, wenn eine vorbestimmte Zeit von da an verstrichen ist, wenn es beginnt, daß das Interferenzlicht zu sehen ist, um Dünnfilmschichtabschnitte (13) der zweiten oberen Beschichtungslage (17) an den beiden seitlichen Seiten des streifen- förmigen Stegs (8) zurückzulassen.

7. Herstellungsverfahren einer Halbleiterlaservorrichtung nach Anspruch 5, bei dem das Verfahren eines Zurücklassens der Dünnfilmschichtabschnitte (13) der zweiten oberen Beschichtungslage (17) die folgenden Schritte aufweist:
Überwachen von Licht einer besonderen Wellenlänge aus Interferenzlicht, welches dadurch erzielt wird, daß Licht, das auf die zweite obere Beschichtungslage (17) strahlt, die durch das Ätzen des Stegs allmählich dünner wird, und durch die zweite obere Beschichtungslage (17) läuft, von der Lichtreflexionsschicht (5) reflektiert wird, um mit dem einfallenden Licht, das durch die zweite obere Beschichtungslage (17) läuft, zu interferieren; und
Stoppen des Ätzens des Stegs, wenn Licht des Lichts der besonderen Wellenlänge eine vorbestimmte Zeitdauer überwacht worden ist, wodurch Dünnfilmschichtabschnitte (13) der zweiten oberen Beschichtungslage (17) an beiden seitlichen Seiten des streifenförmigen Stegs (18) zurückgelassen werden.

8. Herstellungsverfahren einer Halbleiterlaservorrichtung nach Anspruch 4, bei dem das Verfahren eines Zurücklassens der Dünnfilmschichtabschnitte (13) die folgenden Schritte aufweist:
Herstellen einer Rille, die eine Tiefe aufweist, die einer Schichtdicke der Dünnfilmschicht entspricht, in einem Überwachungsbereich (14) an einer oberen Oberfläche der Kontaktschicht (7), die dem Ätzen des Stegs ausgesetzt wird, nach einem Herstellen der Kontaktschicht (7), und wobei sich dieser Überwachungsbereich (14) außerhalb des Bereichs befindet, der ein Laservorrichtungsbereich wird;
Überwachen von Interferenzlicht, welches dadurch erzielt wird, das Licht, das an dem Rillenabschnitt, der durch das Ätzen des Stegs allmählich dünner wird, auf die zweite obere Beschichtungslage (17) strahlt und durch die zweite obere Beschichtungslage (17) läuft, von der Lichtreflexionsschicht (5) reflektiert wird, um mit dem einfallenden Licht, das an dem Rillenabschnitt durch die zweite obere Beschichtungslage (17) läuft, zu interferieren; und
Stoppen des Ätzens, wenn das Interferenzlicht, verschwindet, wodurch Dünnfilmschichtabschnitte (13) an beiden Seiten des Stegbereichsabschnitts (6) der zweiten oberen Beschichtungslage (17) zurückgelassen werden.

## Revendications

1. Dispositif laser à semi-conducteur comprenant :
un substrat (1) semi-conducteur d'un premier type de conductivité ;
une couche (2) de revêtement inférieure du premier type de conductivité disposée sur ledit substrat (1) semi-conducteur du premier type de conductivité ;
une couche (3) active disposée sur ladite couche (2) de revêtement inférieur ;
une première couche (4) de revêtement supérieure d'un second type de conductivité disposée sur ladite couche (3) active, ledit second type de conductivité étant opposé au type de conductivité dudit premier type de conductivité ;
une couche (5) réfléchissant la lumière en Al_{z}Ga_{1-z}AS du second type de conductivité pour réfléchir la lumière étant en incidence sur cette couche pendant la croissance du dispositif laser, disposée sur ladite première couche (4) de revêtement supérueure , où z est égal ou supérieur à 0,6 ;
une seconde couche (17) de revêtement supérieure du second type de conductivité comprenant Al_{y}Ga_{1-y}As, où le rapport de composition en Al y est inférieur audit rapport z de composition en Al, incluant une portion (6) de région d'arête en forme de rayure fournie au centre du dispositif pour produire une arête en forme de rayure et des portions (13) de couche de film fin fournies sur les deux côtés latéraux de ladite portion (6) de région d'arête en forme de rayure, connectées à une portion de fond de ladite portion (6) de région d'arête en forme de rayure, disposée sur ladite couche (5) réfléchissant la lumière ; et
des couches (9) de blocage de courant du premier type de conductivité sur lesdites portions (13) de film fin des deux côtés de ladite seconde couche (17) de revêtement supérieure de façon à enfouir ladite portion (6) de région d'arête de ladite seconde couche (17) de revêtement supérieure produisant une arête en forme de rayure.

2. Dispositif laser à semi-conducteur selon la revendication 1, qui comprend de plus :
une première couche (7) de contact du second type de conductivité, disposée sur ladite portion (6) de région d'arête en forme de rayure de ladite seconde couche (17) de revêtement supérieure pour produire une arête (8) en forme de rayure avec ladite portion (6) de région d'arête en forme de rayure de ladite seconde couche (17) de revêtement supérieure ;
lesdites couches (9) de blocage de courant du premier type de conductivité disposées de façon à enfouir ladite arête (8) en forme de rayure, comprenant ladite portion (6) de région d'arête de ladite seconde couche (17) de revêtement supérieure et de ladite première couche (7) constante.

3. Dispositif laser à semi-conducteur selon la revendication 1 ou 2, dans lequel l'épaisseur totale de ladite première couche (4) de revêtement supérieure, de ladite couche (5) réfléchissant la lumière, de ladite portion (13) de couche de film fin de la seconde couche (17) de revêtement supérieure, est égale à ou inférieure à 0,3 um.

4. Dispositif laser à semi-conducteur selon l'une quelconque des revendications 1 à 3, dans lequel ledit premier type de conductivité est le type n , et ledit second type de conductivité est le type p.

5. Méthode de production d'un dispositif à semi-conducteur comprenant :
sur un premier substrat (1) semi-conducteur, croissance épitaxialement successivement d'une couche (2) de revêtement inférieure d'un premier type de conductivité,d'une couche (3) active,d'une première couche (4) de revêtement supérieure d'un second type de conductivité d'une couche (5) réfléchissant la lumière en Al_{z}Ga_{1-z}AS du second type de conductivité, où z est égal ou supérieur à 0,6 d'une seconde couche (17) de revêtement supérieure du second type de conductivité comprenant Al_{y}Ga_{1-z}As, où le rapport y de composition en Al est inférieur audit rapport z de composition en Al, et d'une couche (7) de formation de couche de contact du second type de conductivité ;
mise en oeuvre d'une gravure sur ladite première couche (7) de formation de couche de contact et de ladite seconde couche (17) de revêtement supérieure, produisant ainsi l'arête (8) en forme de rayure comprenant une première couche (7) de contact et une portion 6) de région d'arête en forme de rayure de ladite seconde couche (17) de revêtement supérieure, tout en laissant des portions (13) de couche de film fin de ladite seconde couche (17)de revêtement supérieure connectées à une portion de fond de ladite portion (6) de région d'arête de ladite seconde couche (7) de revêtement supérieure sur les deux côtés latéraux de ladite arête (8) en forme de rayure, laquelle gravure est contrôlée en observant la lumière d'interférence qui est obtenue à partir de la lumière réfléchie qui résulte de la lumière irradiée vers la seconde couche de revêtement supérieure et, après passage à travers ladite seconde couche de revêtement supérieure, est incidente sur la couche réfléchissant la lumière ;
croissance cristalline de couches (9) de blocage de courant du premier type de conductivité sur lesdites portions (13) de couches de film fin de ladite seconde couche (17) de revêtement supérieure, de façon à enfouir ladite arête (8) en forme de rayure ; et production d'une couche (12) de contact du second type de conductivité sur la surface de sommet entière de ladite première couche (7) de contact de ladite arête (8) en forme de rayure et desdites couches (9) de blocage de courant enfouissant les deux côtés latéraux de celle-ci.

6. Méthode de production d'un dispositif laser à semi-conducteur selon la revendication 5, dans laquelle ledit procédé consistant à laisser ladite portion (13) de couche de film fin de ladite seconde couche (17) de revêtement supérieure, comprend :
l'observation de la lumière d'interférence qui est obtenue par cette lumière irradiée vers ladite seconde couche (17) de revêtement supérieure qui devient graduellement plus fine par la gravure d'arête et passant à travers ladite seconde couche de revêtement supérieure (17) est réfléchie par ladite couche (5) réfléchissant la lumière pour entrer en interférence avec la lumière incidente passant à travers ladite seconde couche (17) de revêtement supérieure ; et
l'arrêt de ladite gravure d'arête lorsqu'un temps prédéterminé s'est écoulé à partir du moment où ladite lumière d'interférence commence à être vue, de façon à laisser des portions (13) de couche de film fin de ladite seconde couche (17) de revêtement supérieure sur les deux côtés latéraux de ladite arête (8) en forme de rayure.

7. Méthode de production d'un dispositif laser à semi-conducteur selon la revendication 5, dans laquelle ledit procédé consistant à laisser lesdites portions (13) de couche de film fin de ladite seconde couche (17) de revêtement supérieure comprend :
l'observation d'une lumière d'une longueur d'onde particulière parmi une lumière d'interférence qui est obtenue par cette lumière irradiée vers ladite seconde couche (17) de revêtement supérieure qui devient graduellement plus fine par la gravure d'arête passant à travers ladite seconde couche (17) de revêtement supérieure est réfléchie par ladite couche (5) réfléchissant la lumière pour entrer en interférence avec la lumière incidente passant à travers ladite seconde couche (17) de revêtement supérieure ; et
l'arrêt de ladite gravure d'arête lorsque la lumière d'une lumière de longueur d'onde particulière est observée un nombre prédéterminé de fois, laissant ainsi des portions (13) de couche de film fin de ladite seconde couche (17) de revêtement supérieure sur les deux côtés latéraux de ladite arête (18) en forme de rayure.

8. Méthode de production d'un dispositif laser à semi-conducteur selon la revendication 4, dans laquelle ledit procédé consistant à laisser lesdites portions (13) de couche de film fin comprend :
après production jusqu'à ladite couche (7) de contact, production dans une région (14) de contrôle une rainure ayant une profondeur correspondant à l'épaisseur de la couche de ladite couche de film fin à une surface de sommet de ladite couche (7) de contact qui est soumise à une gravure d'arête et laquelle région (14) de contrôle est située à l'extérieur de la région pour devenir une région de dispositif laser, en observant la lumière d'interférence qui est obtenue par cette lumière irradiée vers ladite seconde couche (17) de revêtement supérieure sur ladite portion de rainure qui devient graduellement plus fine par la gravure d'arête et passant à travers ladite seconde couche (17) de revêtement supérieure est réfléchie par ladite couche (5) réfléchissant la lumière pour entrer en interférence avec la lumière incidente passant à travers ladite seconde couche (17) de revêtement supérieure sur ladite portion de rainure ; et
arrêt de ladite gravure lorsque ladite lumière d'interférence disparaît, laissant ainsi des portions (13) de couche de film fin sur les deux côtés de ladite portion (6) de région d'arête de ladite seconde couche (17) de revêtement supérieure.
